# EUROPEAN PATENT APPLICATION

(11) **EP 4 545 990 A1**
(43) Date of publication of application: **30.04.2025**
(21) Application number: 24815650.7
(22) Date of filing: 12.01.2024
(51) Int. Cl.: G01R 31/367, G01R 31/36, G01R 31/396, G01R 31/392, G01R 31/382, G06N 3/08, G06N 3/042, G06N 20/00, G06N 3/09

(54) **METHOD AND SYSTEM FOR PREDICTING SOHC FOR ELECTRIC VEHICLE (EV)**

(30) Priority: 30.05.2023 KR 20230069253; 08.01.2024 KR 20240002868
(71) Applicant: LG Energy Solution, Ltd., Seoul 07335 (KR)
(72) Inventor: KIM, Min Young, Daejeon 34122 (KR); PARK, Ji Hye, Daejeon 34122 (KR); CHOI, Jee Soon, Daejeon 34122 (KR)
(74) Representative: Plasseraud IP
(86) International application number: PCT/KR2024/000589
(87) International publication number: WO 2024/248267

(57) **Abstract**

The present invention provides a method and system for estimating a real-time SOHC by generating an SOHC estimation model using cell data and first field data acquired from a test battery and inputting second field data acquired from a battery in use into the SOHC estimation model, in estimating the SOHC of the battery in use.

## Description

### TECHNICAL FIELD

The present invention relates to a method and system for estimating an SOHC of a battery for an electric vehicle (EV) using field data. In particular, it is intended to provide a method and system for calculating an accurate SOHC value of the battery using a machine learning prediction model in a cloud BMS in order to calculate an accurate state of health capacity value of the battery.

### BACKGROUND ART

Conventionally, in estimating the state of health capacity (SOHC) of the battery for the electric vehicle (EV) using field data, a battery capacity value calculated from an on-board battery management system (BMS) was used. However, since the battery capacity value calculated in this way cannot be considered a true value, the SOHC value of the battery estimated using this value contains more errors.

Therefore, a method for calculating the SOHC directly from cell data is needed.

Prior inventions related to this include Patent Document 1, which estimates the remaining life of the battery using an LSTM model, and Patent Document 2, which estimates the dischargeable time of the secondary battery using the neural network.

However, these prior inventions did not present a method of generating an accurate estimation model as in the present invention. In addition, it was not possible to overcome the limitation of using only the on-board calculated value when generating the estimation model.

Related prior arts are as follows.
Patent Document 1: KR 2023-0003848 A (2023.01.06)
Patent Document 2: JP 6250298 B2 (2017.12.01)

### DISCLOSURE OF THE INVENTION

### TECHNICAL PROBLEM

Accordingly, the present invention is intended to solve the problems of the prior art described above and provide a method and system estimating an accurate SOHC of a field battery by generating an accurate SOHC estimation model using cell data acquired during a battery cell test process and using the SOHC estimation model.

### TECHNICAL SOLUTION

Accordingly, the present invention provides an SOHC estimation model generation device including a battery test device that acquires cell data from a plurality of battery cells and first field data from other battery cells or from different charge/discharge cycles during a cell test process, and an SOHC estimation model generation unit that calculates a first SOHC value from the cell data, constructs a first training dataset with the cell data as an input value and the first SOHC value as a label value to generate a first SOHC estimation model that estimates an SOHC value from cell data, inputs the first field data into the first SOHC estimation model to calculate a second SOHC value, constructs a second training dataset with the first field data and the second SOHC value as a label value, and retrains the first SOHC estimation model with the second training dataset to generate a second SOHC estimation model.

In addition, the present invention provides an application BMS that includes an SOHC estimation model unit including an SOHC estimation model, and receives field data from a field battery operating in an application, inputs the field data into the SOHC estimation model, and calculates a real-time SOHC value of the field battery.

In this time, the SOHC estimation model is generated by acquiring cell data from a plurality of battery cells and acquiring first field data from other battery cells or different charge/discharge cycles during a cell test process, calculating a first SOHC value from the cell data, constructing a first training dataset with the cell data and the first SOHC value as a label value to generate a first SOHC estimation model that estimates an SOHC value from cell data, inputting the first field data into the first SOHC estimation model to calculate a second SOHC value, constructing a second training dataset with the first field data and the second SOHC value as a label value, and retraining the first SOHC estimation model with the second training dataset to generate a second SOHC estimation model.

In addition, the present invention provides an SOHC estimation system for a field battery including a battery test device that acquires cell data from a plurality of battery cells and first field data from other battery cells or from different charge/discharge cycles during a cell test process, an SOHC estimation model generation unit that calculates a first SOHC value from the cell data, constructs a first training dataset with the cell data and the first SOHC value as a label value to generate a first SOHC estimation model that estimates an SOHC value from cell data, inputs the first field data into the first SOHC estimation model to calculate a second SOHC value, constructs a second training dataset with the first field data and the second SOHC value as a label value, and retrains the first SOHC estimation model with the second training dataset to generate a second SOHC estimation model, and an application BMS that includes an SOHC estimation model unit including the second SOHC estimation model as an SOHC estimation model, and receives field data from a field battery operating in an application, inputs the field data into the SOHC estimation model, and calculates a real-time SOHC value of the field battery.

In addition, the present invention provides an SOHC estimation method for a field battery cell including a cell data acquisition process of acquiring cell data from a plurality of battery cells during a cell test process, a first SOHC value calculation process of calculating a first SOHC value corresponding to the cell data, a first SOHC estimation model generation process of training and generating a first SOHC estimation model that estimates an SOHC value from cell data using the cell data as an input value and the first SOHC value as a first label value, a first field data acquisition process of acquiring second cell data different from the first field data from a plurality of battery cells during the cell test process, a second SOHC estimation value calculation process of generating a second SOHC estimation value corresponding to first field data by inputting the first field data into the generated first SOHC estimation model, a second SOHC estimation model generation process of generating a second SOHC estimation model by retraining the first SOHC estimation model using the generated second SOHC estimation value as a label value and the first field data as an input value, and an SOHC value estimation process of estimating an SOHC value during operation of predetermined battery cells by inputting field data generated while operating the predetermined battery cells into the second SOHC estimation model.

### ADVANTAGEOUS EFFECTS

According to the present invention, the first SOHC estimation model is generated using cell data obtained during the battery test process, and then the second SOHC estimation model is generated by retraining the first SOHC estimation model using the calculated SOHC value calculated by using the first SOHC estimation model as a label value and apply the second SOHC estimation model as the final SOHC estimation model, thereby providing a estimation model with increased accuracy compared to the prior art using only the on-board calculated capacity value.

### BRIEF DESCRIPTION OF THE DRAWINGS

The following drawings attached to this specification illustrate preferred embodiments of the present invention, and serve to further make the technical idea of the present invention understood along with the detailed description of the invention described above. Accordingly, the present invention should not be construed as limited to only the matters described in such drawings.
FIG. 1 is a block diagram of an SOHC estimation system according to the present invention.
FIG. 2 is a block diagram of an SOHC estimation system according to another embodiment of the present invention.

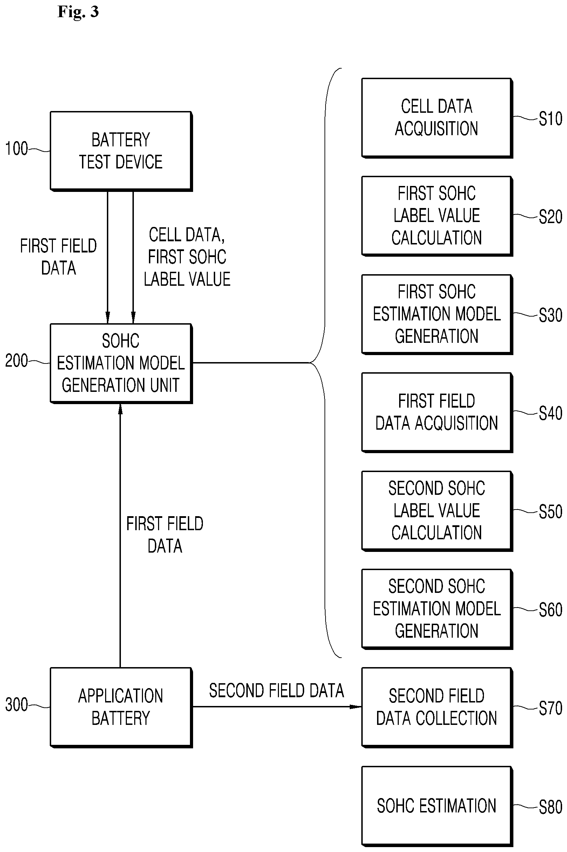

FIG. 3 is a flowchart illustrating an SOHC estimation model generation procedure and an SOHC estimation method using the generated estimation model according to the present invention.

### MODE FOR CARRYING OUT THE INVENTION

The present invention provides a method and system for estimating a real-time SOHC by generating an SOHC estimation model using cell data acquired from a test battery and first field data different the cell data and inputting second field data acquired from a battery in use into the SOHC estimation model, in estimating the SOHC of the battery in use.

### 1. Definition of terms

The terms used in the present invention follow the definitions of the terms described below unless otherwise defined.

The present invention constructs a model that estimates the SOHC of the battery in use from cell data and field data. In the present invention, the state of health capacity (SOHC) means a ratio of capacity reduction due to degradation to an initial capacity of the battery. Generally, it is calculated as SOHC(%) = (current battery capacity/initial battery capacity)×100. Here, the current battery capacity represents an actual capacity of the battery that changes depending on use and charge-discharge cycles, and the initial battery capacity represents the capacity when the battery is first manufactured. It may be judged that the closer the SOHC value is to 100%, the better the health of the battery. It can be regarded that as the SOHC value decreases, the life of the battery is shortened and performance deteriorates.

In the present invention, the cell data means battery cell data acquired from a test battery or reference battery during a cell test process. In the present invention, the field data means battery data acquired from an in-use battery which is being used in an application such as a vehicle.

In the present invention, a cloud battery management system (BMS) means a system in which the battery management function is executed on a cloud server and allows a user to monitor and manage a battery state in real time through a web browser anytime, anywhere. The cloud BMS can centrally and efficiently monitor and control a battery system in various locations, and can collect and analyze data and perform estimation analysis. In addition, the cloud BMS has the effect of optimizing overall energy management by sharing and linking data between multiple systems.

### 2. SOHC estimation system for field battery according to the present invention

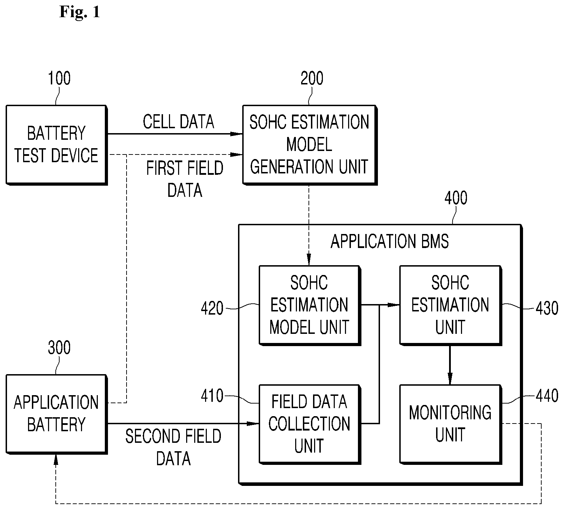

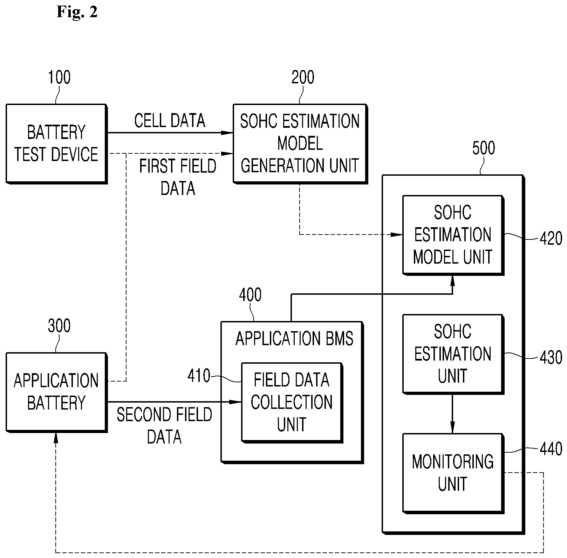

The SOHC estimation system for the field battery according to the present invention is a system that performs a real-time SOHC estimation method for the field battery. The SOHC estimation system of the present invention will be described with reference to FIGS. 1 and 2.

As illustrated in FIG. 1, the system of the present invention includes an SOHC estimation model generation unit 200 and an application BMS 400 that is installed with a generated estimation model, receives second field data from the field battery being used in the application, and calculates a real-time SOHC estimation value of the field battery from this, and the application BMS 400 may be configured as the cloud BMS. In addition, the SOHC estimation model generation unit 200 generates an SOHC estimation model from cell data received from a battery test device 100 and first field data received from an application battery 300.

In another embodiment, as illustrated in FIG. 2, in the system of the present invention, an SOHC estimation model unit 420 and an SOHC estimation unit 430 may be configured as a separate SOHC estimation device 500 instead of being mounted on the application BMS 400.

Hereinafter, each configuration will be described.

### (1) Battery test device 100

The battery test device 100 is a device that performs various tests on the battery after manufacturing the battery. The present invention uses cell data including various state information of test batteries generated during a battery test from the known battery test device 100 as data for generating the SOHC estimation model.

The battery test device 100 acquires the cell data from test batteries and transmits the cell data to the SOHC estimation model generation unit 200.

The types and characteristics of cell data are described later.

### (2) SOHC estimation model generation unit 200

The SOHC estimation model generation unit 200 is a configuration that generates an SOHC estimation model using not only the cell data described above but also first field data, and includes a computer algorithm that performs a corresponding process. The present invention uses a known neural network as a neural network that is the basis of the SOHC estimation model, and is characterized by data and a training method for training the SOHC estimation model.

The SOHC estimation model generator 200 generates the SOHC estimation model by performing processes S10 to S60 described later, and provides the generated estimation model, that is, a computer-implemented algorithm for calculating an SOHC prediction value of the battery, to the SOHC estimation model unit 420 online or offline.

The SOHC estimation model generation unit 420 obtains the cell data and first SOHC value, which is an SOHC value corresponding to the cell data, as a first label value from the battery test device or a previously secured reference data set, constructs a first training dataset with the cell data and the first SOHC value, which is the first label value, and generates a first SOHC estimation model that estimates the SOHC value from the cell data. The first SOHC value is the SOHC value calculated based on the cell data from an on-board BMS of the test battery, a predetermined artificial neural network model configured to estimate the SOHC value from cell data may be used as the first SOHC estimation model, and a support vector regression (SVR) model is applied thereto in one embodiment, and a first SOHC estimation model is obtained by performing machine learning that obtains a first parameter set including coefficients, intercepts, and model parameters that determine the regression function of the SVR model, by using the first training dataset with the cell data as input and the first SOHC value as a label value. The first training data set is {cell data, first SOHC}.

After that, the SOHC estimation model generation unit 420 acquires first field data from a predetermined field battery and inputs the first field data into the first SOHC estimation model to calculate a second SOHC value as a second label value, and constructs a second training dataset {first field data, second SOHC value} with the first field data as an input value and the second SOHC value as a label value. The second SOHC value is an SOHC value calculated by inputting the first field data into the first SOHC estimation model.

In another embodiment, first field data may be obtained from the battery test device 100. In this case, the battery test device 100 acquires cell data, which is obtained from a test battery other than the test battery from which the cell data was obtained, or from charge/discharge cycles different from those when the cell data was acquired, as first field data. In this case as well, the second training data set is set to {first field data, second SOHC value}.

After that, a second SOHC estimation model is generated by retraining the first SOHC estimation model with the second training dataset to obtain the second parameter set, and the second SOHC estimation model is provided as a final SOHC estimation model. The provided second SOHC estimation model is installed on the SOHC estimation model unit 420 of the application BMS 400, which will be described later.

### (3) Application BMS(400)

The application BMS 400 of the present invention is a battery management device that manages the application battery 300, and may be configured to include a field data collection unit 410, the SOHC estimation model unit 420, the SOHC estimation unit 430, and a monitoring unit 440, in addition to typical BMS components.

The application BMS 400 of the present invention collects field data such as battery state information from the application battery 300 in operation, and may be configured as an on-site battery management system (on-Site BMS) configured in the same location or facility as the application battery, or may be configured as the cloud BMS.

When the application BMS 400 is configured as the cloud BMS, the application BMS 400 is connected to a plurality of on-board BMSs through a predetermined wired/wireless communication network and receives the cell data and field data from the on-board BMSs.

In the present invention, the on-board BMS means the BMS of the application battery 300 or the test battery from which the first SOHC value is calculated, and the on-Site BMS means that the application BMS 400, which receives field data from the on-board BMSs of a plurality of application batteries 300, is physically the same as or adjacent to the application battery 300, to form one system. When the application BMS 400 is separated from the application battery 300 and configured to receive the field data through a wired/wireless network, it is referred to as the cloud BMS.

Such an application BMS 400 includes the following configurations in addition to a data path connected to a plurality of application batteries 300 or a communication device (not illustrated) connected to a wired/wireless network.

### A. Field data collection unit 410

The field data collection unit 410 collects field data from the battery used in the application and transmits the field data to the SOHC estimation unit 430. The field data collected by the field data collection unit 410 is indicated as second field data in FIGS. 1 and 2 in order to distinguish the field data from first field data for retraining the SOHC estimation model.

### B. SOHC estimation model unit 420

The SOHC estimation model unit 420 is configured with a memory device installed with the SOHC estimation model generated according to an SOHC estimation model generation method according to the present invention, which will be described later. The SOHC estimation model is a computer-implemented algorithm that constructs an artificial neural network model which receives field data in real time and is trained to calculate a real-time SOHC estimation value of the application battery 300 corresponding to the real-time field data.

### C. SOHC estimation unit 430

The SOHC estimation unit 430 reads the computer-implemented algorithm constructing the SOHC estimation model, inputs the field data into the SOHC estimation model, and outputs an SOHC estimation value corresponding to the field data. It may be configured with a processor of a computer device or an arithmetic device including a predetermined processor.

### D. Monitoring unit 440

The monitoring unit 440 monitors the state of the application battery 300 based on the real-time SOHC estimation value calculated by the SOHC estimation unit 430.

As described above, the application BMS 400 of the present invention may be mounted on an application device such as a vehicle, or may be configured as the cloud battery management system BMS. When it is configured as the cloud BMS, the cloud BMS may include a communication module that receives the field data from a remote location from the application battery 300.

Meanwhile, as illustrated in FIG. 2, the SOHC estimation system according to another embodiment of the present invention may be configured as a separate SOHC estimation device 500 without configuring the SOHC estimation model unit 420, SOHC estimation unit 430, and monitoring unit 440 within the application BMS 400.

### 3. Method for estimating SOHC of cell in use of the present invention

The present invention estimates and calculates the SOHC of the cell in use through the following procedure.

### (1) Cell data acquisition process (S10)

This is a process of acquiring cell data from a plurality of battery cells during a cell testing process after cell manufacturing. The cell data may include at least one of a cumulative charge capacity during a charge cycle, a cumulative discharge capacity during a discharge cycle, cumulative charge energy, which is energy required for charging during the charge cycle, cumulative discharge energy, which is discharge energy during the discharge cycle, and an average temperature data of the battery cell, of the battery cell.

Preferably, the cell data may be limited to cell data obtained in a standard charge section, which has similar characteristics to field data and is a relatively standardized section. For standard charging, the charging speed can be set to 0.33 C-rate. The reason for limiting cell data to data obtained in the standard charge section is to secure cell data obtained in a test environment in a section similar to field data, which is data in an actual use environment.

More preferably, the cell data may be limited to cell data obtained in a predetermined partial charge section. In this case, the partial charge section may be a section of 3.6 to 3.9 V. The reason for limiting cell data to a predetermined partial charge section is to extract a common voltage section and extract a voltage section that has a high correlation with SOHC, during the battery test process, because there is a difference in charging start voltage for each cell in each cycle. As a result of checking the correlation between SOHC and cell voltage in 0.1 V units through experiments, the inventor of the present invention confirmed that the correlation between SOHC and cell voltage was high in the 3.6 to 3.8 V section.

### (2) First SOHC label value calculation process (S20)

This is a process of calculating the cell SOHC value corresponding to the cell data during the cell test process after cell manufacturing.

The first SOHC value calculated by the BMS during the test process after manufacturing the cell is the value calculated by the on-board BMS. The BMS at this time may be the on-board BMS used in the cell test process. As the method of calculating the first SOHC using cell data in the on-board BMS, a known method is used.

### (3) First SOHC estimation model generation process (S30)

The first SOHC estimation model that estimates the SOHC value from the cell data is generated using the acquired cell data as input data and the first SOHC value corresponding thereto as a label value. The first SOHC estimation model is generated by performing machine learning on a known neural network-based model using the cell data and a first SOHC label value corresponding thereto.

### (4) First field data acquisition process (S40)

Meanwhile, the present invention acquires first field data from the application battery 300 operating in an actual application, different from the test battery from which the cell data is acquired during the cell test process. Like cell data, the first field data is also composed of data including at least one of a cumulative charge capacity during a charge cycle, a cumulative discharge capacity during a discharge cycle, cumulative charge energy, which is energy required for charging during the charge cycle, cumulative discharge energy, which is discharge energy during the discharge cycle, and an average temperature data of the battery cell, of the battery cell, but is different in that the first field data is battery data obtained from a battery in operation in an actual application.

Meanwhile, the first field data may be data acquired from a battery different from the battery for acquiring the second field data, which will be described later, or may be data acquired in cycles different from the charge/discharge cycles for acquiring the second field data.

### (5) Second SOHC label value calculation process (S50)

This is a process of inputting the first field data into the first SOHC estimation model to calculate the second SOHC label values corresponding to the first field data.

### (6) Second SOHC estimation model generation process (S60)

This is the process of generating the second SOHC estimation model by retraining the first SOHC estimation model. The process of generating the second SOHC estimation model is a process of generating the second SOHC estimation model by retraining the first SOHC estimation model with {first field data, second SOHC calculated value}, which is obtained by using the first field data as input data to the first SOHC estimation model and the second SOHC calculated value calculated from the first SOCH estimation model as a label value, as training data.

### (7) Second field data collection process (S70)

This is the process of collecting second field data from the field battery in operation in an application for which it is intended to estimate the SOHC. Like cell data, the second field data also includes at least one of a cumulative charge capacity during a charge cycle of the battery cell, a cumulative discharge capacity during a discharge cycle, cumulative charge energy, which is energy required for charging during the charge cycle, cumulative discharge energy, which is discharge energy during the discharge cycle, and an average temperature data of the battery cell.

### (8) SOHC estimation process for field battery (S80)

This is the process of calculating the real-time SOHC value of the field battery (application battery) by inputting the collected field data (second field data) into the second SOHC estimation model.

As described above, the disclosed embodiments have been described with reference to the accompanying drawings. A person skilled in the art to which the present invention pertains will understand that the present invention may be practiced in forms different from the disclosed embodiments without changing the technical idea or essential features of the present invention. The disclosed embodiments are illustrative and should not be construed as limiting.

The names of parts illustrated in the drawing of the present invention are as follows.
100: battery test device 200: SOHC estimation model generation unit
300: application battery 400: application BMS
410: field data collection unit 420: SOHC estimation model unit
430: SOHC estimation unit 440: monitoring unit
500: SOHC estimation device

## Claims

1. An SOHC estimation model generation device comprising:
a battery test device that acquires a first cell data from a plurality of battery cells during a cell test process; and
an SOHC estimation model generation unit that
calculates a first SOHC value from the first cell data, constructs a first training dataset with the first cell data as an input value and the first SOHC value as a label value to generate a first SOHC estimation model that estimates an SOHC value from cell data,
generates a first SOHC estimation model by training a predetermined artificial neural network using {first cell data, first SOHC value} as first training data, and generates a second SOHC estimation model by retraining the first SOHC estimation model using {first field data, second SOHC value} as second training data, wherein the first field data is battery data acquired from an application battery in operation, or cell data acquired from test battery cells other than the first test battery cells from which the first cell data was acquired, or cell data acquired from the first test battery cells in different charge/discharge cycles in which the first cell data was acquired,
the first SOHC value is calculated from the first cell data, and
the second SOHC value is a value calculated by inputting the first field data into the first SOHC estimation model.

2. An application BMS that comprises an SOHC estimation model unit including an SOHC estimation model, and receives field data from an application battery in operation in an application, inputs the field data into the SOHC estimation model, and calculates a real-time SOHC value of the application battery.

3. The application BMS of claim 2, wherein
the SOHC estimation model is generated by
generating a first SOHC estimation model through machine learning performed by using {cell data, first SOHC value} as first training data and
retraining the first SOHC estimation model with {first field data, second SOHC value} as second training data,
the cell data is battery data obtained from a test battery,
the first field data is battery data acquired from an operating application battery,
the first SOHC value is calculated from the cell data, and
the second SOHC value is a value calculated by inputting the first field data into the first SOHC estimation model.

4. The application BMS of claim 3, further comprising:
a field data collection unit that receives first field data and second field data from the application battery through a predetermined communication network, wherein
the SOHC estimation model receives the second field data from the application battery and calculates the real-time SOHC value of the application battery.

5. An SOHC estimation system for an application battery comprising:
a battery test device that acquires cell data from a plurality of battery cells during a cell test process; and
an application BMS that receives field data from an application battery in operation in an application and inputs the field data into the SOHC estimation model, and calculates a real-time SOHC value of the application battery, wherein
the application BMS comprises
an SOHC estimation model generation unit that calculates a first SOHC value from the cell data, constructs a first training dataset with the cell data as an input value and the first SOHC value as a label value to generate a first SOHC estimation model that estimates an SOHC value from cell data, generates a first SOHC estimation model by training a predetermined artificial neural network using {cell data, first SOHC value} as first training data, and generates a second SOHC estimation model by retraining the first SOHC estimation model using {first field data, second SOHC value} as second training data, and
an SOHC estimation model unit that comprises the second SOHC estimation model as a SOHC estimation model,
the first SOHC value is calculated from the cell data, and
the second SOHC value is a value calculated by inputting the first field data into the first SOHC estimation model.

6. The SOHC estimation system of claim 5, wherein
the cell data or first field data comprises at least one of
cumulative charge capacity, cumulative discharge capacity, cumulative charge energy, cumulative discharge energy, and average temperature data, of a battery cell.

7. The SOHC estimation system of claim 6, wherein
the first field data is data obtained in a standard charge section and a predetermined partial charge section.

8. An SOHC estimation method for a field battery cell, comprising:
a cell data acquisition process of acquiring cell data from a plurality of battery cells during a cell test process;
a first SOHC value calculation process of calculating a first SOHC value corresponding to the cell data;
a first SOHC estimation model generation process of generating a first SOHC estimation model that estimates an SOHC value from cell data by performing machine learning using training data set with the cell data as an input value and the first SOHC value as a first label value;
a first field data acquisition process of acquiring second cell data different from the first field data from a plurality of battery cells during the cell test process;
a second SOHC estimation value calculation process of generating a second SOHC estimation value corresponding to first field data by inputting the first field data into the generated first SOHC estimation model;
a second SOHC estimation model generation process of generating a second SOHC estimation model by retraining the first SOHC estimation model using the generated second SOHC estimation value as a label value and the first field data as an input value; and
an SOHC value estimation process of estimating an SOHC value during operation of predetermined battery cells by inputting field data generated while operating the predetermined battery cells into the second SOHC estimation model.

9. The SOHC estimation method of claim 8, wherein
the cell data or first field data comprises at least one of
cumulative charge capacity, cumulative discharge capacity, cumulative charge energy, cumulative discharge energy, and average temperature data, of a battery cell.

10. The SOHC estimation method of claim 9, wherein
the first field data is acquired from battery cells different from the test battery cells from which the cell data was acquired, or acquired from charge/discharge cycles different from the charge/discharge cycles from which the cell data was acquired.

11. The SOHC estimation method of claim 10, wherein
the first field data is data obtained in a standard charge section and a predetermined partial charge section.

12. The SOHC estimation method of claim 11, wherein
the first SOHC estimation model and the second SOHC estimation model are regression models or artificial neural network models generated through supervised learning.
